# EUROPEAN PATENT SPECIFICATION

(11) **EP 2 982 998 B1**
(45) Date of publication and mention of the grant of the patent: **07.11.2018**
(21) Application number: 15179633.1
(22) Date of filing: 04.08.2015
(51) Int. Cl.: G01R 31/34, G01R 31/28, G01R 31/42, G06F 17/50, H02P 23/00

(54) **TEST APPARATUS, TEST METHOD AND TEST SYSTEM FOR VARIABLE SPEED CONTROLLER**
TESTVORRICHTUNG, TESTVERFAHREN UND TESTSYSTEM FÜR STEUERUNG VARIABLER GESCHWINDIGKEITEN
APPAREIL DE TEST, PROCÉDÉ DE TEST ET SYSTÈME DE TEST POUR COMMANDE À VITESSE VARIABLE

(30) Priority: 06.08.2014 JP 2014160651
(43) Date of publication of application: 10.02.2016
(73) Proprietor: Kabushiki Kaisha Toshiba, Minato-ku Tokyo 105-8001 (JP)
(72) Inventor: KUSUNOKI, Kiyoshi, Tokyo 105-8001 (JP); KAGEYAMA, Takahisa, Tokyo 105-8001 (JP); KIJI, Junichi, Tokyo 105-8001 (JP)
(74) Representative: AWA Sweden AB

(56) References cited:
- US-A- 5 729 118
- US-A1- 2007 143 090
- US-A1- 2012 274 289
- Greg Yohe ET AL: "Improved Governor Response at the Dinorwig Power Station", , 1 January 2013 (2013-01-01), pages 1-18, XP055230661, Retrieved from the Internet: URL:http://www.americangovernor.com/wp-con tent/uploads/2013/04/Improved-Governor-Res ponse-at-the-Dinorwig-Power-Plant.pdf [retrieved on 2015-11-24]
- "Testing Motor Controllers Using FPGA-Based High-Speed Hardware-in-the-Loop Simulators - National Instruments", , 5 July 2011 (2011-07-05), XP055230772, Retrieved from the Internet: URL:http://www.ni.com/example/31159/en/ [retrieved on 2015-11-24]
- "eDRIVEsim: Electric Drives and Power Electronics Hardware in the Loop Test Benches", , 1 January 2010 (2010-01-01), pages 1-16, XP055230769, Retrieved from the Internet: URL:http://www.opal-rt.com/sites/default/f iles/eDRIVEsim_brochure_regular.pdf [retrieved on 2015-11-24]
- MAHDI DARGAHI ET AL: "Studies in power hardware in the loop (PHIL) simulation using real-time digital simulator (RTDS)", POWER ELECTRONICS, DRIVES AND ENERGY SYSTEMS (PEDES), 2012 IEEE INTERNATIONAL CONFERENCE ON, IEEE, 16 December 2012 (2012-12-16), pages 1-6, XP032346557, DOI: 10.1109/PEDES.2012.6484500 ISBN: 978-1-4673-4506-4
- Marco Mauri: "Hardware in the loop simulation of renewable distributed generation systems", Renewable Energy, 1 December 2009 (2009-12-01), pages 133-152, XP055230657, ISBN: 978-953-76-1952-7 Retrieved from the Internet: URL:http://www.intechopen.com/books/renewa ble-energy/hardware-in-the-loop-simulation -of-renewabledistributed-generation-system s [retrieved on 2015-11-24]

## Description

Embodiments described herein relate generally to an armature winding of an electrical rotating apparatus, an electrical rotating apparatus using the same, and a method of manufacturing the same.

Embodiments described herein relate generally to a test apparatus, a test method and a test system for a variable speed controller that controls a variable speed system including a variable speed AC machine and a power converter. Variable speed controllers are previously known for example from *Improved Governor Response at the Dinorwig Power Station* (Yohe, Greg et al. Systems for testing power management control systems and/or variable speed controlles have previously been disclosed for example in US2007/143090 A1, by National Instruments in *Testing* Motor *Controllers Using FPGA-Based High-Speed Hardware-in-the-Loop Simulators, and* in *eDRIVEsim:Electric Drives and Power Electronics HW in the Loop Test Behches".*

A synchronous machine rotates at a constant rotating speed synchronous with the frequency of a power system. If the frequency of the power supplied to the synchronous machine is adjusted by a power converter, the rotating speed of the synchronous machine can be adjusted. The rotating speed of a duplex feeding AC machine can be adjusted by employing a power converter and controlling frequencies of the voltage and current supplied to a secondary winding. A typical system that utilizes this principle is a variable speed pumped-storage power generating system.

The variable speed pumped-storage power generating system comprises, as major apparatuses, a pump turbine (a prime mover), a duplex feeding generator motor (a duplex feeding AC machine) and a secondary excitation apparatus (a power converter). The generator motor is connected to a power system through a major transformer. The power converter is connected to the major transformer by way of a power-converter transformer. The variable speed controller controls the guide vane of the pump turbine and the power converter to control the input/output and the rotating speed of the variable speed pumped-storage power generating system.

In order to improve the reliability of a factory test, it may be desirable to execute the test, using the variable speed controller and apparatuses to be controlled thereby in combination. However, in the case of a large-scale system, such as a variable speed pumped-storage power generating system, it is practically difficult to combine, in a factory, the variable speed controller with the pump turbine, generator motor and power converter which are to be controlled by the variable speed controller. Even if the variable speed controller can be combined with all apparatus to be controlled, it is still difficult to perform a combination test in a factory in the state where actual water supply systems and power system are connected. Conventionally, therefore, a small-sized test apparatus simulating the variable speed pumped-storage power generating system is combined with the variable speed controller for the combination test.

The steady-state characteristics and the dynamic characteristics of the variable speed pumped-storage power generating system can be simulated using a small-sized test apparatus made by a rotary machine. Since the reactance and resistance components of the actual apparatuses are hard to simulate using the small-sized apparatus, electromagnetic transient phenomena of the actual apparatus cannot be accurately measured using the small-sized test apparatus. For this reason, in a factory test, the transient phenomena at the time of the failure of the power system cannot be accurately simulated, and the characteristics of the variable speed controller panel cannot be confirmed.

Under the circumstances, it is desired to provide a test apparatus, test method and test system for a variable speed controller, which enable the behaviors of an actual variable speed system to be simulated without the need to employ the actual systems.

The invention can be more fully understood from the following detailed description when taken in conjunction with the accompanying drawings, in which:
FIG. 1 is a diagram illustrating the basic structure of a variable speed pumped-storage power generating system according to one embodiment;
FIG. 2 shows an example of a configuration used for a test in which the variable speed controller depicted in FIG. 1 is combined with a predetermined test apparatus (simulation apparatus);
FIG. 3 shows an example of a configuration of a transfer function which the duplex feeding generator motor computation unit depicted in FIG. 2 uses for computing the behaviors of a duplex feeding generator motor;
FIG. 4 shows an example of a configuration of a transfer function which the major transformer computation unit depicted in FIG. 2 uses for computing the behaviors of the duplex feeding generator motor;
FIG. 5 illustrates an example of a test operation according to the embodiment; and
FIG. 6 shows a modification of the configuration depicted in FIG. 2 (i.e., an example of a configuration applied to a full converter system).

In general, according to one embodiment, there is provided a test apparatus for a variable speed controller, which simulates behaviors of a variable speed system including a prime mover, an AC machine and a power converter. The test apparatus includes a prime mover computation unit which computes behaviors of the prime mover, using a state quantity regarding the prime mover and a predetermined transfer function; an AC machine computation unit which computes behaviors of the AC machine, using a state quantity regarding the AC machine and a predetermined transfer function; and a power converter computation unit which computes behaviors of the power converter, using a state quantity regarding the power converter and a predetermined transfer function, wherein each of the computation units us computation results of other computation units.

Hereinafter, an embodiment will be described with reference to the drawings.

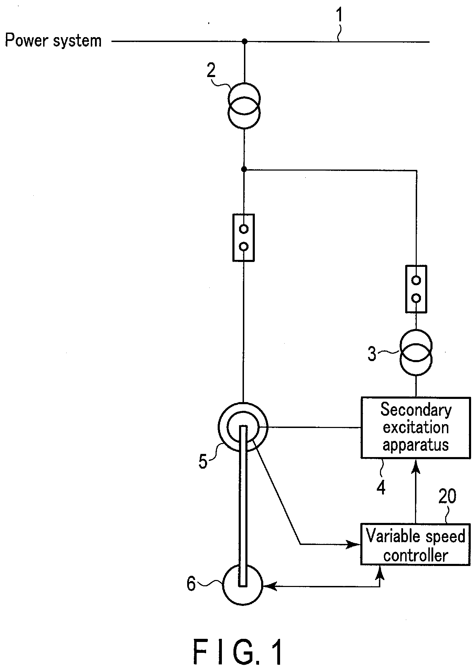

FIG. 1 is a diagram illustrating the basic structure of a variable speed pumped-storage power generating system according to one embodiment.

The variable speed pumped-storage power generating system comprises the following as major components: a major transformer 2 including a first winding connected to a duplex feeding generator motor 5 (a duplex feeding AC machine) and a second winding connected to a power system 1; a secondary-excitation-apparatus transformer 3 used as a power-supply transformer for a secondary excitation apparatus 4; a secondary excitation apparatus (a power converter) 4 including a frequency converter for applying a variable-frequency AC voltage to the secondary winding of the duplex feeding generator motor 5; the duplex feeding generator motor 5; a pump turbine (a prime mover) 6 coupled to the duplex feeding generator motor 5; and a variable speed controller 20 configured to control at least the secondary excitation apparatus 4 and the pump turbine 6.

The variable speed controller 20 has (i) a secondary excitation apparatus control function for controlling the AC voltage, current, frequency and phase output from the secondary excitation apparatus 4, and (ii) a pump turbine control function (including a governor control function) for controlling the output of the pump turbine 6, for example, by properly opening the guide vanes.

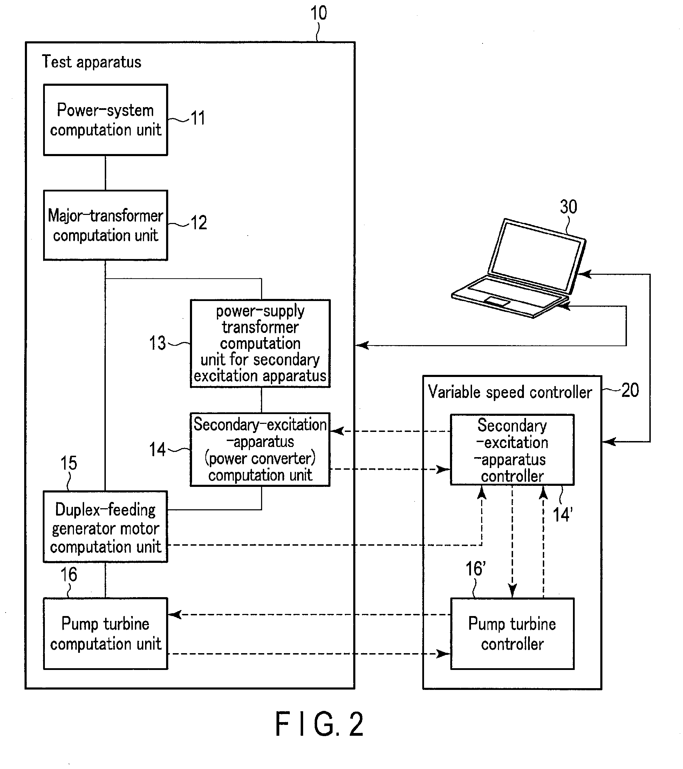

FIG. 2 shows an example of a configuration used for a test in which the variable speed controller 20 depicted in FIG. 1 is combined with a predetermined test apparatus (simulation apparatus).

The test apparatus (simulation apparatus) 10 can be realized, for example, by using a central processing unit (CPU), a program and an interface with an apparatus external to the test apparatus. Based on computations, the test apparatus simulates behaviors (dynamic characteristics) of the variable speed pumped-storage power generating system including the power system 1, major transformer 2, secondary-excitation-apparatus power-supply transformer 3, secondary excitation apparatus 4, and duplex feeding generator motor 5 mentioned above. The test apparatus 10 is used in combination with the variable speed controller 20. During a test, the test apparatus 10 changes its condition in accordance with control signals supplied from the variable speed controller 20, and supplies signals indicative of various conditions to the variable speed controller 20.

During the test, the variable speed controller 20 checks the various states indicated by the signals supplied from the test apparatus 10 and supplies control signals for controlling the variable speed pumped storage power generating system to the test apparatus 10.

When the test is performed using the test apparatus 10 and the variable speed controller 20 in combination, the computer 30 is connected to both the test apparatus 10 and the variable speed controller 20. The computer 30 enables the constantly-changing conditions of the variable speed pumped-storage power generating system to be monitored on a display in real time based on a control operation of the variable speed controller 20 and a simulating operation of the test apparatus 10.

The test apparatus 10 comprises various computation units, including a power-system computation unit 11, a major-transformer computation unit 12, secondary-excitation-apparatus power-supply transformer computation unit 13, a secondary-excitation-apparatus (power converter) computation unit 14, a duplex-feeding generator motor computation unit 15 and a pump turbine computation unit 16. Each of these computation units performs its operation using computation results of the other computation units. On the other hand, the variable speed controller 20 comprises a secondary-excitation-apparatus controller 14' by which the above-mentioned secondary-excitation apparatus control function is attained, and a pump turbine controller 16' by which the above-mentioned pump turbine control function is attained.

The power-system computation unit 11 receives a computation result of the major-transformer computation unit 12 and performs computation using a state quantity regarding the power system 1 and a predetermined transfer function to detect the behaviors of the power system 1.

The major-transformer computation unit 12 receives a computation result of the duplex-feeding generator motor computation unit 15 and a computation result of the secondary-excitation-apparatus power-supply transformer computation unit 13 and computes the behaviors of the major transformer, using a state quantity regarding the major transformer 2 and a predetermined transfer function to detect.

The secondary-excitation-apparatus power-supply transformer computation unit 13 receives a computation result of the major-transformer computation unit 12, a computation result of the duplex-feeding generator motor computation unit 15, and a computation result of the secondary-excitation-apparatus computation unit 14 and computes the behaviors of the secondary-excitation-apparatus power-supply transformer 3, using a state quantity regarding the secondary-excitation-apparatus power-supply transformer 3 and a predetermined transfer function.

The secondary-excitation-apparatus computation unit 14 receives a computation result supplied from the secondary-excitation-apparatus controller 14' and computes the behaviors of the secondary excitation apparatus 4, using a state quantity regarding the secondary excitation apparatus 4 and a predetermined transfer function. The computation result, thus obtained, is supplied to the secondary-excitation-apparatus controller 14'.

The duplex-feeding generator motor computation unit 15 receives a computation result of the pump turbine computation unit 16, a computation result of the secondary-excitation-apparatus computation unit 14, and a computation result of the major-transformer computation unit 12 and computes the behaviors of the duplex feeding generator motor 5, using a state quantity regarding the duplex feeding generator motor 5 and a predetermined transfer function. The computation result, thus obtained, is supplied to the secondary-excitation-apparatus controller 14'.

The pump turbine computation unit 16 receives a computation result supplied from the pump turbine controller 16' and computes the behaviors of the pump turbine 6, using a state quantity regarding the pump turbine 6 and a predetermined transfer function. The computation result, thus obtained, is supplied to the pump turbine controller 16'.

All or some of the transfer functions used by the computation units 11 to 16 include a variable constant. The variable constant varies in accordance with at least one of the computation results or state quantities of the computation units 11 to 16.

The state quantity used by the secondary-excitation-apparatus (power converter) computation unit 14 is, for example, at least one of an output frequency, a output voltage, an output current, a DC voltage, an input frequency, an input voltage and an input current. The variable constant includes, for example, at least one of a mutual reactance (Xm), a primary reactance (X1), a secondary reactance (X2), a primary resistance (R1) and a secondary resistance (R2) of a power-supply transformer 3 for the power converter.

The state quantity regarding the duplex-feeding generator motor computation unit 15 is, for example, at least one of a rotating speed, a slip, an axial output, an axial input, a primary frequency, a primary voltage, a primary current, a secondary frequency, a secondary voltage, a secondary current, an output voltage of the power converter, and an input voltage of the power converter. The variable constant includes, for example, at least one of a mutual reactance (Xm), a primary reactance (X1), a secondary reactance (X2), a primary resistance (R1) and a secondary resistance (R2) of the duplex feeding generator motor 5 (a duplex feeding AC machine).

The state quantity used by the pump turbine computation unit 16 is, for example, at least one of a rotating speed, an output, an input, a flow rate, a head drop, a pump head, and a pressure. The variable constant is, for example, a time constant of a water channel.

The secondary-excitation-apparatus controller 14' grasps the state of the secondary excitation apparatus 4 based on the computation result supplied from the secondary-excitation-apparatus computation unit 14, grasps the state of the duplex feeding generator motor 5 based on the computation result supplied from the duplex-feeding generator motor computation unit 15, and grasps the state of the pump turbine 6 based on the signals supplied from the pump turbine controller 16'. Using the information, the secondary-excitation-apparatus controller 14' determines a control amount for controlling the secondary excitation apparatus 4, and supplies a signal for the control to the secondary-excitation-apparatus computation unit 14.

The pump turbine controller 16' grasps the state of the pump turbine 6 based on the computation result supplied from the pump turbine computation unit 16. Using the information on the signals supplied from the secondary-excitation-apparatus controller 14', the pump turbine controller 16' determines a control amount for controlling the pump turbine 6 and supplies a signal for the control to the pump turbine computation unit 16.

In the example shown in FIG. 2, all of the functions of the computation units 11-16 are realized by one test apparatus, but this configuration is not restrictive and may be modified. For example, the functions of computation units 11-15 may be realized by one test apparatus 10, and the function of computation unit 16 may be realized by another test apparatus. More specifically, for example, the functions may be realized using two central processing units (CPU), programs executed by them, interfaces with apparatus external to the test apparatus, etc. The functions of the computation units may be distributed among three or more test apparatuses 10. In addition, some of the computation units may be collectively handled as an operation group, and the operations of such computation units may be executed like batch processing. In FIG. 2, the computer 30 is shown as being connected to the variable speed controller 20. However, the computer 30 may be connected to the test apparatus 10 and/or variable speed controller 20. In this case, constantly-changing conditions of the variable speed pumped-storage power generating system can be monitored in real time by the test apparatus 10 and/or the variable speed controller 20 based on a control operation of the variable speed controller 20 and a simulating operation of the test apparatus 10.

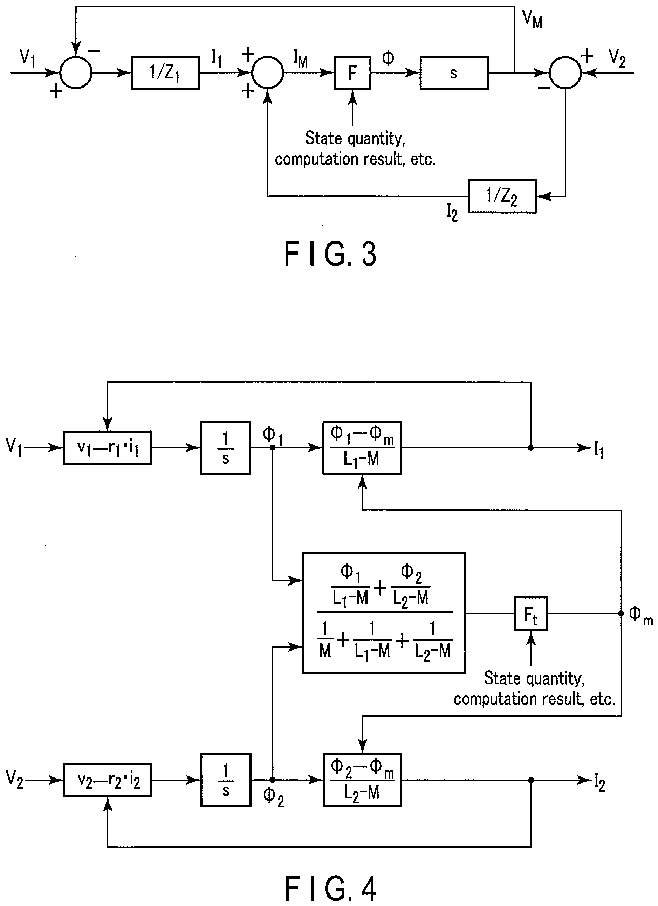

FIG. 3 shows an example of a configuration of a transfer function which the duplex feeding generator computation unit 15 depicted in FIG. 2 uses for computing the behaviors of the duplex feeding generator motor 5.

In the transfer function shown in FIG. 3, V₁ denotes a primary voltage, V₂ denotes a secondary voltage, I₁ denotes a primary current, I₂ denotes a secondary current, Z₁ denotes the impedance of a primary winding, and Z₂ denotes the impedance of a secondary winding.

Φ denotes a magnetic flux interlinking the primary winding and the secondary winding, and s denotes a Laplace operator.

F denotes a variable constant representing the relation between excitation current I_{M} and magnetic flux Φ. For example, the variable constant includes at least one of a mutual reactance Xm, a primary reactance X1, a secondary reactance X2, a primary resistance R1, and a secondary resistance R2 of the duplex feeding generator motor 5.

The variable constant F varies in accordance with the state quantity regarding the duplex-feeding generator motor 5. The state quantity includes, for example, at least one of a rotating speed, a slip, an axial output, an axial input, a primary frequency, a primary voltage, a primary current, a secondary frequency, a secondary voltage, a secondary current, an output voltage of the power converter, and an input voltage of the power converter.

FIG. 4 shows an example of a configuration of a transfer function which the major-transformer computation unit 12 uses for computing the behaviors of the major transformer 2.

In the transfer function shown in FIG. 4, V₁ denotes a primary voltage, V₂ denotes a secondary voltage, I₁ denotes a primary current, I₂ denotes a secondary current, L₁ denotes an inductance of a primary winding, L₂ denotes an inductance of a secondary winding, and M denotes a mutual inductance.

Φ₁ denotes a magnetic flux interlinking the primary winding, Φ₂ denotes a magnetic flux interlinking the secondary winding, Φₘ denotes a magnetic flux interlinking both the primary winding and the secondary winding, and s denotes a Laplace operator.

The variable constant Fₜ varies in accordance with the state quantity regarding the major transformer 2 (which includes, for example, at least one of a primary frequency, a primary voltage, a primary current, a magnetic flux interlinking the primary winding, a secondary frequency, a secondary voltage, a secondary current, and a magnetic flux interlinking the secondary winding), a computation result of the power-system computation unit 11, a computation result of the secondary-excitation-apparatus power-supply transformer computation unit 13, and/or a computation result of the duplex feeding generator computation unit 15.

Furthermore, the variable constant F varies in accordance with a computation result of the pump turbine computation unit 16, a computation result of the secondary-excitation-apparatus computation unit 14, and a computation result of the major-transformer computation unit 12.

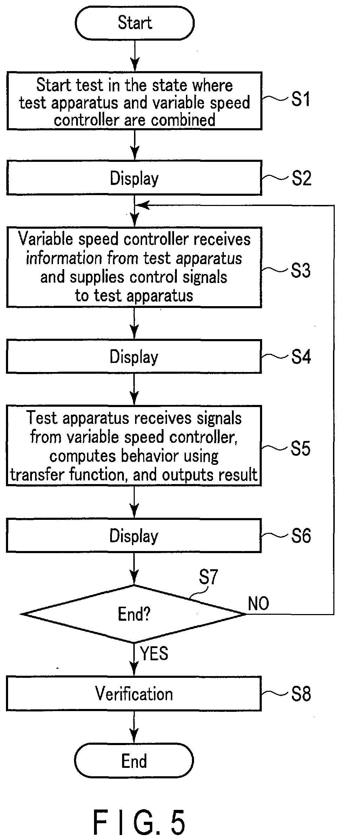

A description will now be given of an example of operation, referring to the flowchart shown in FIG. 5.

The test of the control system of the variable speed pumped-storage power generating system is started in the state where the test apparatus 10 and the variable speed controller 20 are combined (Step S1). The computer 30 is connected to the variable speed controller 20, and the state of the control system is displayed on the display screen of the computer 30 (Step S2).

The variable speed controller 20 receives information supplied from the test apparatus 10 and checks the states of the test apparatus 10. In accordance with the detected state of the test apparatus 10, the variable speed controller 20 supplies control signals for the variable speed pumped storage power generating system to the test apparatus 10 (Step S3). The state of the control system is displayed on the display screen of the computer 30 (Step S4). On the other hand, the test apparatus 10 receives signals for various kinds of control from the variable speed controller 20, computes a behavior using a transfer function, and supplies a computation result to the variable speed controller 20 (Step S5). The state of the control system is displayed on the display screen of the computer 30 (Step S6).

Steps S3 to S6 are repeated until the end of a series of operations (NO in Step S7). At the end of the series of operations (YES in Step S7), necessary processing such as verification of the test results is performed (Step S8), and the test is brought to an end.

In the example of the flowchart shown in FIG. 5, Steps S3 to S6 are shown as being executed in this order, for easy understanding of the invention. In practice, however, Steps S3 to D6 can be executed simultaneously.

In general, in an equation of state used to compute behaviors in the conventional art, a circuit constant is a fixed value, and the relation between state quantities is expressed as being linear, that is, by a fixed constant. Therefore, if the relation between state quantities is nonlinear, representative points are used for linear approximation. For example, the excitation characteristics of a duplex feeding AC machine, i.e., the current and the magnetic flux, are not proportional, and saturation may occur when the current is in the vicinity of a rated excitation current. For this reason, the excitation current and the excitation voltage may not be accurately simulated in an over-load state or in an over-voltage state. In the conventional art, moreover, the dynamic characteristics of a prime mover with a variable-flowrate water channel system cannot be simulated. Therefore, the effect which another system sharing the same water channel may have cannot be sequentially simulated. For example, it is not possible to simulate behaviors which a system may take immediately after a load is shut off or immediately after the number of units in operation is changed.

The present embodiment provides a solution to the above problem of the conventional art. The constant used in a transfer function is a variable constant which varies in accordance with the state quantity regarding each apparatus. The use of the variable constant enables accurate simulation of nonlinear characteristics between state quantities. In addition, the dynamic characteristics of a generator motor with a water channel system can be simulated. By so doing, the turbine speed torque characteristics can be simulated accurately even after the opening of a flow regulating valve is changed or the operating condition of another system is changed. As a result, a factory test can be performed for a variable speed controller panel under conditions similar to those under which the variable speed controller panel is combined with actual systems.

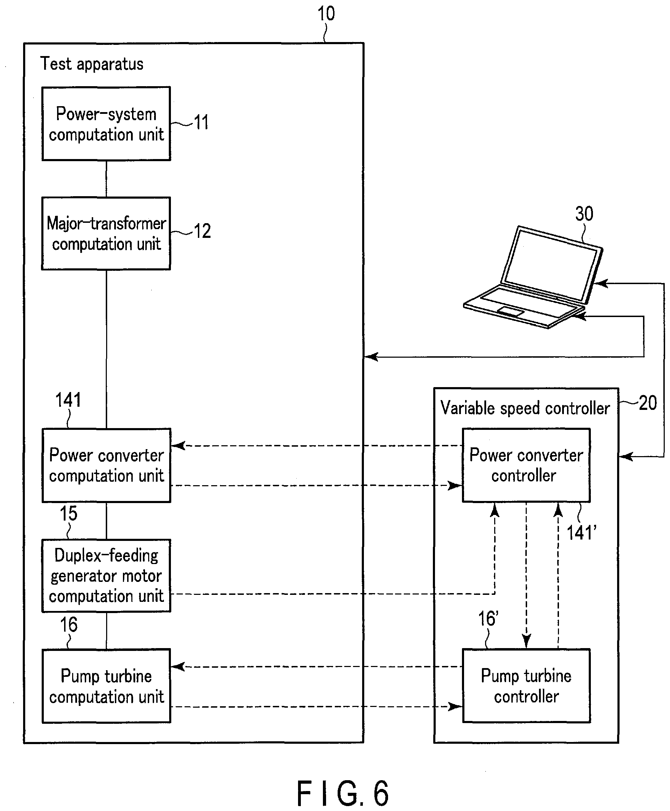

In connection with the foregoing embodiment, reference was made to a test apparatus used in a variable speed pumped-storage power generating system of secondary excitation type. A test apparatus used in combination with a variable speed pumped-storage power generating system of full converter type can be designed in a similar manner. An example of such a configuration is shown in FIG. 6.

FIG. 6 shows a modification of the configuration depicted in FIG. 2. The configuration shown in FIG.6 differs from that shown in FIG. 2 in that the variable speed controller 20 comprises a power converter controller 141' in place of the secondary-excitation-apparatus controller 14' and in that the test apparatus 10 comprises a power converter computation unit 141 in place of the secondary-excitation-apparatus power-supply transformer computation unit 13 and the secondary-excitation-apparatus (power converter) computation unit 14. The operations performed by the test apparatus 10 and the variable speed controller 20 shown in FIG. 6 are similar to those explained above.

As described above in detail, the embodiment (and the modification) enables the behaviors of an actual variable speed system to be accurately simulated without the need to employ a test apparatus incorporating actual systems or rotary machines.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. The accompanying claims are intended to cover such forms or modifications as would fall within the scope of the inventions.

## Claims

1. A test apparatus (10) for a variable speed controller (20), which simulates behaviors of a variable speed system including a prime mover (6), an AC machine (5) and a power converter (4), the test apparatus (10) comprising:
a prime mover computation unit (16) which computes behaviors of the prime mover (6), using a state quantity regarding the prime mover (6) and a predetermined transfer function;
an AC machine computation unit (15) which computes behaviors of the AC machine (5), using a state quantity regarding the AC machine (5) and a predetermined transfer function; and
a power converter computation unit (14) which computes behaviors of the power converter (4), using a state quantity regarding the power converter (4) and a predetermined transfer function,
wherein each of the computation units uses computation results of other computation units, and
**characterised in that** a constant in the transfer function used in each of the computation units is a variable constant that varies in accordance with the state quantity regarding each of the prime mover (6), the AC machine (5), and the power converter (4) respectively.

2. The test apparatus (10) according to claim 1, **characterized in that** the variable constant varies in accordance with at least one of a computation result of the prime mover (6), a computation result of the AC machine computation unit (15), and a computation result of the power converter computation unit (14).

3. The test apparatus (10) according to claim 1 or 2, **characterized in that** the state quantity used by the prime mover computation unit (16) includes at least one of a rotating speed, an output, an input, a flow rate, a head drop, a pump head, and a pressure, and the variable constant is a time constant of a water channel.

4. The test apparatus (10) according to claim 1 or 2, **characterized in that**:
the state quantity used by the AC machine computation unit (15) is at least one of a rotating speed, a slip, an axial output, an axial input, a primary frequency, a primary voltage, a primary current, a secondary frequency, a secondary voltage, a secondary current, an output voltage of the power converter (4), and an input voltage of the power converter (4), and
the variable constant includes at least one of a mutual reactance (Xm), a primary reactance (X1), a secondary reactance (X2), a primary resistance (R1) and a secondary resistance (R2) of the AC machine (5).

5. The test apparatus (10) according to claim 1 or 2, **characterized in that**:
the state quantity used by the power converter computation unit (14) is at least one of an output frequency, a output voltage, an output current, a DC voltage, an input frequency, an input voltage and an input current, and
the variable constant includes at least one of a mutual reactance (Xm), a primary reactance (X1), a secondary reactance (X2), a primary resistance (R1) and a secondary resistance (R2) of a power-supply transformer (3) for the power converter (4).

6. A test apparatus (10) for a variable speed controller (20), which simulates behaviors of a variable speed system including an AC machine (5) and a power converter (4), the test apparatus (10) comprising:
an AC machine computation unit (15) which computes behaviors of the AC machine (5), using a state quantity regarding the AC machine (5) and a predetermined transfer function; and
a power converter computation unit (141) which computes behaviors of the power converter (4), using a state quantity regarding the power converter (4) and a predetermined transfer function,
wherein each of the computation units uses computation results of other computation units, and
**characterised in that** a constant in the transfer function used in each of the computation units is a variable constant that varies in accordance with the state quantity regarding each of the AC machine (5) and the power converter (4) respectively.

7. The test apparatus (10) according to claim 6, **characterized in that** the variable constant varies in accordance with at least one of a computation result of the AC machine computation unit (15) and a computation result of the power converter computation unit (141).

8. The test apparatus (10) according to claim 6 or 7, **characterized in that**:
the state quantity used by the AC machine computation unit (15) is at least one of a rotating speed, a slip, an axial output, an axial input, a primary frequency, a primary voltage, a primary current, a secondary frequency, a secondary voltage, a secondary current, an output voltage of the power converter (4), and an input voltage of the power converter (4), and
the variable constant includes at least one of a mutual reactance (Xm), a primary reactance (X1), a secondary reactance (X2), a primary resistance (R1) and a secondary resistance (R2) of the AC machine (5).

9. The test apparatus (10) according to claim 6 or 7, **characterized in that**:
the state quantity used by the power converter computation unit (141) is at least one of an output frequency, a output voltage, an output current, a DC voltage, an input frequency, an input voltage and an input current, and
the variable constant includes at least one of a mutual reactance (Xm), a primary reactance (X1), a secondary reactance (X2), a primary resistance (R1) and a secondary resistance (R2) of a power-supply transformer (3) for the power converter (4).

10. A test method of performing a test using a variable speed controller (20) and a test apparatus (10) in combination, the variable speed controller (20) controlling at least one of a prime mover (6), an AC machine (5) and a power converter (4), and the test apparatus (10) simulating a variable speed system including the prime mover (6), the AC machine (5) and the power converter (4), the test method comprising:
a generator motor computing step of computing behaviors of the prime mover (6), using a state quantity regarding the prime mover (6) and a predetermined transfer function;
an AC machine computing step of computing behaviors of the AC machine (5), using a state quantity regarding the AC machine (5) and a predetermined transfer function; and
a power converter computing step of computing behaviors of the power converter (4), using a state quantity regarding the power converter (4) and a predetermined transfer function,
wherein each of computing steps uses computation results of other computing steps, and
**characterised in that** a constant in the transfer function used in each of the computation steps is a variable constant that varies in accordance with the state quantity regarding each of the prime mover (6), the AC machine (5), and the power converter (4) respectively.

11. A test method of performing a test using a variable speed controller (20) and a test apparatus (10) in combination, the variable speed controller (20) controlling at least one of an AC machine (5) and a power converter (4), and the test apparatus (10) simulating a variable speed system including the AC machine (5) and the power converter (4), the test method comprising:
an AC machine computing step of computing behaviors of the AC machine (5), using a state quantity regarding the AC machine (5) and a predetermined transfer function; and
a power converter computing step of computing behaviors of the power converter (4), using a state quantity regarding the power converter (4) and a predetermined transfer function,
wherein each of computing steps uses computation results of other computing steps, and
**characterised in that** a constant in the transfer function used in each of the computation steps is a variable constant that varies in accordance with the state quantity regarding each of the AC machine (5) and the power converter (4) respectively.

12. A test system which performs a test, using in combination a test apparatus (10) according to any one of claims 1 to 5, and a variable speed controller (20) for controlling at least one of the prime mover (6), the AC machine (5) and the power converter (4).

13. A test system which performs a test, using in combination a test apparatus (10) according to any one of claims 6 to 9, and a variable speed controller (20) for controlling at least one of the AC machine (5) and the power converter (4).

## Patentansprüche

1. Eine Prüfvorrichtung (10) für eine variable Geschwindigkeitssteuerung (20), die Verhaltensweisen eines variablen Geschwindigkeitssystems simuliert, das einen Antriebsmotor (6), eine AC-Maschine (5) und einen Leistungswandler (4) umfasst, wobei die Prüfvorrichtung (10) aufweist:
eine Antriebsmotor-Berechnungseinheit (16), die Verhaltensweisen des Antriebsmotors (6) unter Verwendung einer Zustandsgröße bezüglich des Antriebsmotors (6) und einer vorbestimmten Übertragungsfunktion berechnet;
eine AC-Maschine-Berechnungseinheit (15), die Verhaltensweisen der AC-Maschine (5) unter Verwendung einer Zustandsgröße bezüglich der AC-Maschine (5) und einer vorbestimmten Übertragungsfunktion berechnet; und
eine Leistungswandler-Berechnungseinheit (14), die Verhaltensweisen des Leistungswandlers (4) unter Verwendung einer Zustandsgröße bezüglich des Leistungswandlers (4) und einer vorbestimmten Übertragungsfunktion berechnet,
wobei jede der Berechnungseinheiten Berechnungsergebnisse anderer Berechnungseinheiten verwendet, und
**dadurch gekennzeichnet, dass** eine Konstante in der Übertragungsfunktion, die in jeder der Berechnungseinheiten verwendet wird, eine variable Konstante ist, die in Übereinstimmung mit der Zustandsgröße bezüglich jeweils des Antriebsmotors (6), der AC-Maschine (5) und des Leistungswandlers (4) variiert.

2. Die Prüfvorrichtung (1) gemäß Anspruch 1, **dadurch gekennzeichnet, dass** die variable Konstante in Übereinstimmung mit mindestens einem von einem Berechnungsergebnis des Antriebsmotors (6), einem Berechnungsergebnis der AC-Maschine-Berechnungseinheit (15) und einem Berechnungsergebnis der Leistungswandler-Berechnungseinheit (14) variiert.

3. Die Prüfvorrichtung gemäß Anspruch 1 oder 2, **dadurch gekennzeichnet, dass** die Zustandsgröße, die durch die Antriebsmotor-Berechnungseinheit (16) verwendet wird, wenigstens eine von einer Drehzahl, einer Ausgabe, einer Eingabe, einer Flussrate, einer Kopfabsenkung, einem Pumpenkopf und einem Druck umfasst, und die variable Konstante eine Zeitkonstante eines Wasserkanals ist.

4. Die Prüfvorrichtung gemäß Anspruch 1 oder 2, **dadurch gekennzeichnet, dass**:
die Zustandsgröße, die von der AC-Maschine-Berechnungseinheit (15) verwendet wird, ist wenigstens eine von einer Drehzahl, einem Schlupf, einer Axialausgabe, einer Axialeingabe, einer Primärfrequenz, einer Primärspannung, eines Primärstroms, einer Sekundärfrequenz, einer Sekundärspannung, eines Sekundärstroms, einer Ausgangsspannung des Leistungswandlers (4), und einer Eingangsspannung des Leistungswandlers (4) und
die variable Konstante umfasst wenigstens einen von einer gegenseitigen Reaktanz (Xm), einer Primärreaktanz (X1), einer Sekundärreaktanz (X2), eines Primärwiderstands (R1) und eines Sekundärwiderstands (R2) der AC-Maschine (5).

5. Die Prüfvorrichtung (10) gemäß Anspruch 1 oder 2, **dadurch gekennzeichnet, dass**:
die Zustandsgröße, die von der Leistungswandler-Berechnungseinheit (14) verwendet wird, wenigstens eine von einer Ausgangsfrequenz, einer Ausgangsspannung, einem Ausgangsstrom, einer DC-Spannung, einer Eingangsfrequenz, einer Eingangsspannung und einem Eingangsstrom ist, und
die variable Konstante wenigstens eine von einer gegenseitigen Reaktanz (Xm), einer Primärreaktanz (X1), einer Sekundärreaktanz (X2), einem Primärwiderstand (R1) und einem Sekundärwiderstand (R2) eines Leistungsversorgungstransformators (3) des Leistungswandlers (4) umfasst.

6. Eine Prüfvorrichtung für eine variable Geschwindigkeitssteuerung (20), die Verhaltensweisen eines variablen Geschwindigkeitssystems simuliert, das eine AC-Maschine (5) und einen Leistungswandler (4) umfasst, wobei die Prüfvorrichtung (10) aufweist:
eine AC-Maschine-Berechnungseinheit (15), die Verhaltensweisen der AC-Maschine (5) unter Verwendung einer Zustandsgröße bezüglich der AC-Maschine (5) und einer vorbestimmten Übertragungsfunktion berechnet; und
eine Leistungswandler-Berechnungseinheit (141), die Verhaltensweisen des Leistungswandlers (4) unter Verwendung einer Zustandsgröße bezüglich des Leistungswandlers (4) und einer vorbestimmten Übertragungsfunktion berechnet,
wobei jede der Berechnungseinheiten Berechnungsergebnisse anderer Berechnungseinheiten verwendet, und
**dadurch gekennzeichnet, dass** eine Konstante in der Übertragungsfunktion, die in jeder der Berechnungseinheiten verwendet wird, eine variable Konstante ist, die in Übereinstimmung mit der Zustandsgröße bezüglich jeweils der AC-Maschine (5) und des Leistungswandlers (4) variiert.

7. Die Prüfvorrichtung (1) gemäß Anspruch 6, **dadurch gekennzeichnet, dass** die variable Konstante in Übereinstimmung mit mindestens einem von einem Berechnungsergebnis der AC-Maschine-Berechnungseinheit (15) und einem Berechnungsergebnis der Leistungswandler-Berechnungseinheit (141) variiert.

8. Die Prüfvorrichtung gemäß Anspruch 6 oder 7, **dadurch gekennzeichnet, dass**:
die Zustandsgröße, die von der AC-Maschine-Berechnungseinheit (15) verwendet wird, ist wenigstens eine von einer Drehzahl, einem Schlupf, einer Axialausgabe, einer Axialeingabe, einer Primärfrequenz, einer Primärspannung, eines Primärstroms, einer Sekundärfrequenz, einer Sekundärspannung, eines Sekundärstroms, einer Ausgangsspannung des Leistungswandlers (4), und einer Eingangsspannung des Leistungswandlers (4) und
die variable Konstante umfasst wenigstens einen von einer gegenseitigen Reaktanz (Xm), einer Primärreaktanz (X1), einer Sekundärreaktanz (X2), eines Primärwiderstands (R1) und eines Sekundärwiderstands (R2) der AC-Maschine (5).

9. Die Prüfvorrichtung (10) gemäß Anspruch 6 oder 7, **dadurch gekennzeichnet, dass**:
die Zustandsgröße, die von der Leistungswandler-Berechnungseinheit (141) verwendet wird, wenigstens eine von einer Ausgangsfrequenz, einer Ausgangsspannung, einem Ausgangsstrom, einer DC-Spannung, einer Eingangsfrequenz, einer Eingangsspannung und einem Eingangsstrom ist, und
die variable Konstante umfasst wenigstens eines von einer gegenseitigen Reaktanz (Xm), einer Primärreaktanz (X1), einer Sekundärreaktanz (X2), einem Primärwiderstand (R1) und einem Sekundärwiderstand (R2) eines Leistungsversorgungstransformators (3) des Leistungswandlers (4).

10. Ein Prüfverfahren zur Durchführung einer Prüfung unter Verwendung einer variablen Geschwindigkeitssteuerung (20) und einer Prüfvorrichtung (10) in Kombination, wobei die variable Geschwindigkeitssteuerung (20) wenigstens einen von einem Antriebsmotor (6), einer AC-Maschine (5) und einem Leistungswandler (4) steuert, und die Prüfvorrichtung (10) ein variables Geschwindigkeitssystem simuliert, das den Antriebsmotor (6), die AC-Maschine (5) und den Leistungswandler (4) umfasst, wobei das Prüfverfahren aufweist:
einen Generator-Motor-Berechnungsschritt zum Berechnen von Verhaltensweisen des Antriebsmotors (6) unter Verwendung einer Zustandsgröße bezüglich des Antriebsmotors (6) und einer vorbestimmten Übertragungsfunktion;
einen AC-Maschine-Berechnungsschritt zum Berechnen von Verhaltensweisen der AC-Maschine (5) unter Verwendung einer Zustandsgröße bezüglich der AC-Maschine (5) und einer vorbestimmten Übertragungsfunktion; und
einen Leistungswandler-Berechnungsschritt zum Berechnen von Verhaltensweisen des Leistungswandlers (4) unter Verwendung einer Zustandsgröße bezüglich des Leistungswandlers (4) und einer vorbestimmten Übertragungsfunktion,
wobei jeder der Berechnungsschritte Berechnungsergebnisse der anderen Berechnungsschritte nutzt, und
**dadurch gekennzeichnet, dass** eine Konstante in der Übertragungsfunktion, die in jedem der Berechnungsschritte verwendet wird, eine variable Konstante ist, die in Übereinstimmung mit der Zustandsgröße bezüglich jeweils des Antriebsmotors (6), der AC-Maschine (5) und des Leistungswandlers (4) variiert.

11. Ein Prüfverfahren zur Durchführung einer Prüfung unter Verwendung einer variablen Geschwindigkeitssteuerung (20) und einer Prüfvorrichtung (10) in Kombination, wobei die variable Geschwindigkeitssteuerung (20) wenigstens einen von einer AC-Maschine (5) und einem Leistungswandler (4) steuert, und die Prüfvorrichtung (10) ein variables Geschwindigkeitssystem simuliert, das die AC-Maschine (5) und den Leistungswandler (4) umfasst, wobei das Prüfverfahren aufweist:
einen AC-Maschine-Berechnungsschritt zum Berechnen von Verhaltensweisen der AC-Maschine (5) unter Verwendung einer Zustandsgröße bezüglich der AC-Maschine (5) und einer vorbestimmten Übertragungsfunktion; und
einen Leistungswandler-Berechnungsschritt zum Berechnen von Verhaltensweisen des Leistungswandlers (4) unter Verwendung einer Zustandsgröße bezüglich des Leistungswandlers (4) und einer vorbestimmten Übertragungsfunktion,
wobei jeder der Berechnungsschritte Berechnungsergebnisse der anderen Berechnungsschritte nutzt, und
**dadurch gekennzeichnet, dass** eine Konstante in der Übertragungsfunktion, die in jedem der Berechnungsschritte verwendet wird, eine variable Konstante ist, die in Übereinstimmung mit der Zustandsgröße bezüglich jeweils der AC-Maschine (5) und des Leistungswandlers (4) variiert.

12. Ein Prüfsystem, das eine Prüfung unter Verwendung einer Kombination einer Prüfvorrichtung (10) gemäß einem der Ansprüche 1 bis 5 und einer variablen Geschwindigkeitssteuerung (20) zum Steuern von wenigstens einem von einem Antriebsmotor (6), einer AC-Maschine (5) und einem Leistungswandler (4) durchführt.

13. Ein Prüfsystem, das eine Prüfung unter Verwendung einer Kombination einer Prüfvorrichtung (10) gemäß einem der Ansprüche 6 bis 9 und einer variablen Geschwindigkeitssteuerung (20) zum Steuern von wenigstens einem von einer AC-Maschine (5) und einem Leistungswandler (4) durchführt.

## Revendications

1. Appareil de test (10) pour une unité de commande à vitesse variable (20), qui simule les comportements d'un système à vitesse variable comportant un moteur principal (6), une machine à courant alternatif (5) et un convertisseur de puissance (4), l'appareil de test (10) comprenant :
une unité de calcul de moteur principal (16) qui calcule les comportements du moteur principal (6), en utilisant une grandeur d'état concernant le moteur principal (6) et une fonction de transfert prédéterminée ;
une unité de calcul de machine à courant alternatif (15) qui calcule les comportements de la machine à courant alternatif (5), en utilisant une grandeur d'état concernant la machine à courant alternatif (5) et une fonction de transfert prédéterminée ; et
une unité de calcul de convertisseur de puissance (14) qui calcule les comportements du convertisseur de puissance (4), en utilisant une grandeur d'état concernant le convertisseur de puissance (4) et une fonction de transfert prédéterminée,
dans lequel chacune des unités de calcul utilise les résultats de calcul d'autres unités de calcul, et
**caractérisé en ce que**
une constante dans la fonction de transfert utilisée dans chacune des unités de calcul est une constante variable qui varie en fonction de la grandeur d'état concernant chacun du moteur principal (6), de la machine à courant alternatif (5), et du convertisseur de puissance (4) respectivement.

2. Appareil de test (10) selon la revendication 1, **caractérisé en ce que** la constante variable varie en fonction d'au moins l'un d'un résultat de calcul du moteur principal (6), d'un résultat de calcul de l'unité de calcul de machine à courant alternatif (15), et d'un résultat de calcul de l'unité de calcul de convertisseur de puissance (14).

3. Appareil de test (10) selon la revendication 1 ou 2, **caractérisé en ce que** la grandeur d'état utilisée par l'unité de calcul de moteur principal (16) comporte au moins l'un(e) d'une vitesse de rotation, d'une sortie, d'une entrée, d'un débit, d'une dénivellation, d'une tête de pompe, et d'une pression, et la constante variable est une constante de temps d'un canal d'eau.

4. Appareil de test (10) selon la revendication 1 ou 2, **caractérisé en ce que** :
la grandeur d'état utilisée par l'unité de calcul de machine à courant alternatif (15) est au moins l'un(e) d'une vitesse de rotation, d'un glissement, d'une sortie axiale, d'une entrée axiale, d'une fréquence primaire, d'une tension primaire, d'un courant primaire, d'une fréquence secondaire, d'une tension secondaire, d'un courant secondaire, d'une tension de sortie du convertisseur de puissance (4), et d'une tension d'entrée du convertisseur de puissance (4), et
la constante variable comporte au moins l'une d'une réactance mutuelle (Xm), d'une réactance primaire (X1), d'une réactance secondaire (X2), d'une résistance primaire (R1) et d'une résistance secondaire (R2) de la machine à courant alternatif (5).

5. Appareil de test (10) selon la revendication 1 ou 2, **caractérisé en ce que** :
la grandeur d'état utilisée par l'unité de calcul de convertisseur de puissance (14) est au moins l'un(e) d'une fréquence de sortie, d'une tension de sortie, d'un courant de sortie, d'une tension continue, d'une fréquence d'entrée, d'une tension d'entrée et d'un courant d'entrée ;
la constante variable comporte au moins l'une d'une réactance mutuelle (Xm), d'une réactance primaire (X1), d'une réactance secondaire (X2), d'une résistance primaire (R1) et d'une résistance secondaire (R2) d'un transformateur d'alimentation électrique (3) pour le convertisseur de puissance (4).

6. Appareil de test (10) pour une unité de commande à vitesse variable (20), qui simule les comportements d'un système à vitesse variable comportant une machine à courant alternatif (5) et un convertisseur de puissance (4), l'appareil de test (10) comprenant :
une unité de calcul de machine à courant alternatif (15) qui calcule les comportements de la machine à courant alternatif (5), en utilisant une grandeur d'état concernant la machine à courant alternatif (5) et une fonction de transfert prédéterminée ; et
une unité de calcul de convertisseur de puissance (141) qui calcule les comportements du convertisseur de puissance (4), en utilisant une grandeur d'état concernant le convertisseur de puissance (4) et une fonction de transfert prédéterminée,
dans lequel chacune des unités de calcul utilise les résultats de calcul d'autres unités de calcul, et
**caractérisé en ce que**
une constante dans la fonction de transfert utilisée dans chacune des unités de calcul est une constante variable qui varie en fonction de la grandeur d'état concernant chacun de la machine à courant alternatif (5) et du convertisseur de puissance (4) respectivement.

7. Appareil de test (10) selon la revendication 6, **caractérisé en ce que** la constante variable varie en fonction d'au moins l'un d'un résultat de calcul de l'unité de calcul de machine à courant alternatif (15) et d'un résultat de calcul de l'unité de calcul de convertisseur de puissance (141).

8. Appareil de test (10) selon la revendication 6 ou 7, **caractérisé en ce que** :
la grandeur d'état utilisée par l'unité de calcul de machine à courant alternatif (15) est au moins l'un(e) d'une vitesse de rotation, d'un glissement, d'une sortie axiale, d'une entrée axiale, d'une fréquence primaire, d'une tension primaire, d'un courant primaire, d'une fréquence secondaire, d'une tension secondaire, d'un courant secondaire, d'une tension de sortie du convertisseur de puissance (4), et d'une tension d'entrée du convertisseur de puissance (4), et
la constante variable comporte au moins l'une d'une réactance mutuelle (Xm), d'une réactance primaire (X1), d'une réactance secondaire (X2), d'une résistance primaire (R1) et d'une résistance secondaire (R2) de la machine à courant alternatif (5).

9. Appareil de test (10) selon la revendication 6 ou 7, **caractérisé en ce que** :
la grandeur d'état utilisée par l'unité de calcul de convertisseur de puissance (141) est au moins l'un(e) d'une fréquence de sortie, d'une tension de sortie, d'un courant de sortie, d'une tension continue, d'une fréquence d'entrée, d'une tension d'entrée et d'un courant d'entrée ; et
la constante variable comporte au moins l'une d'une réactance mutuelle (Xm), d'une réactance primaire (X1), d'une réactance secondaire (X2), d'une résistance primaire (R1) et d'une résistance secondaire (R2) d'un transformateur d'alimentation électrique (3) pour le convertisseur de puissance (4).

10. Procédé de test pour effectuer un test en utilisant une unité de commande à vitesse variable (20) et un appareil de test (10) en combinaison, l'unité de commande à vitesse variable (20) commandant au moins l'un(e) d'un moteur principal (6), d'une machine à courant alternatif (5) et d'un convertisseur de puissance (4), et l'appareil de test (10) simulant un système à vitesse variable comportant le moteur principal (6), la machine à courant alternatif (5) et le convertisseur de puissance (4), le procédé de test comprenant :
une étape de calcul de moteur de générateur qui consiste à calculer les comportements du moteur principal (6), en utilisant une grandeur d'état concernant le moteur principal (6) et une fonction de transfert prédéterminée ;
une étape de calcul de machine à courant alternatif qui consiste à calculer les comportements de la machine à courant alternatif (5), en utilisant une grandeur d'état concernant la machine à courant alternatif (5) et une fonction de transfert prédéterminée ; et
une étape de calcul de convertisseur de puissance qui consiste à calculer les comportements du convertisseur de puissance (4), en utilisant une grandeur d'état concernant le convertisseur de puissance (4) et une fonction de transfert prédéterminée,
dans lequel chacune des étapes de calcul utilise les résultats de calcul d'autres étapes de calcul, et
**caractérisé en ce que**
une constante dans la fonction de transfert utilisée dans chacune des étapes de calcul est une constante variable qui varie en fonction de la grandeur d'état concernant chacun du moteur principal (6), de la machine à courant alternatif (5), et du convertisseur de puissance (4) respectivement.

11. Procédé de test qui consiste à effectuer un test en utilisant une unité de commande à vitesse variable (20) et un appareil de test (10) en combinaison, l'unité de commande à vitesse variable (20) commandant au moins l'un(e) d'une machine à courant alternatif (5) et d'un convertisseur de puissance (4), et l'appareil de test (10) simulant un système à vitesse variable comportant la machine à courant alternatif (5) et le convertisseur de puissance (4), le procédé de test comprenant :
une étape de calcul de machine à courant alternatif qui consiste à calculer les comportements de la machine à courant alternatif (5), en utilisant une grandeur d'état concernant la machine à courant alternatif (5) et une fonction de transfert prédéterminée ; et
une étape de calcul de convertisseur de puissance qui consiste à calculer les comportements du convertisseur de puissance (4), en utilisant une grandeur d'état concernant le convertisseur de puissance (4) et une fonction de transfert prédéterminée,
dans lequel chacune des étapes de calcul utilise les résultats de calcul d'autres étapes de calcul, et
**caractérisé en ce que**
une constante dans la fonction de transfert utilisée dans chacune des étapes de calcul est une constante variable qui varie en fonction de la grandeur d'état concernant respectivement chacun de la machine à courant alternatif (5) et du convertisseur de puissance (4).

12. Système de test qui effectue un test, en utilisant en combinaison un appareil de test (10) selon l'une quelconque des revendications 1 à 5, et une unité de commande à vitesse variable (20) pour commander au moins l'un(e) du moteur principal (6), de la machine à courant alternatif (5) et du convertisseur de puissance (4).

13. Système de test qui effectue un test, en utilisant en combinaison un appareil de test (10) selon l'une quelconque des revendications 6 à 9, et une unité de commande à vitesse variable (20) pour commander au moins l'un(e) de la machine à courant alternatif (5) et du convertisseur de puissance (4).
